# EUROPEAN PATENT SPECIFICATION

(11) **EP 1 018 171 B1**
(45) Date of publication and mention of the grant of the patent: **14.06.2006**
(21) Application number: 98914230.2
(22) Date of filing: 26.02.1998
(51) Int. Cl.: H01L 39/12

(54) **CERAMIC/METAL SUPERCONDUCTING COMPOSITE MATERIAL EXPLOITING SUPERCONDUCTING PROXIMITY EFFECT**
KERAMIK/METALL SUPRALEITENDES VERBUNDMATERIAL UNTER AUSNUTZUNG DES SUPRALEITENDEN NAHWIRKUNGSEFFEKTS
MATERIAU COMPOSITE SUPRACONDUCTEUR CERMET TIRANT PROFIT DE L'EFFET DE PROXIMITE SUPRACONDUCTEUR

(30) Priority: 26.02.1997 US 806697
(43) Date of publication of application: 12.07.2000
(73) Proprietor: THE BOARD OF TRUSTEES OF THE LELAND STANFORD JUNIOR UNIVERSITY, Stanford, CA 94304 (US)
(72) Inventor: HOLCOMB, Matthew, J., El Segundo, CA 90245 (US)
(74) Representative: Casey, Lindsay Joseph
(86) International application number: PCT/US1998/003818
(87) International publication number: WO 1998/038684

(56) References cited:
- EP-A- 0 284 986
- EP-A- 0 292 126
- EP-A- 0 323 239
- WO-A-89/01706
- WO-A-93/17969
- DE-A- 1 490 242
- DE-A- 2 516 747
- US-A- 4 575 927
- US-A- 4 971 944
- US-A- 4 999 338
- US-A- 5 041 416
- US-A- 5 091 362
- US-A- 5 098 178
- US-A- 5 226 947
- US-A- 5 248 661
- US-E- R E32 178
- ORTABASI U ET AL: "Enhanced critical currents by high pressure impregnation of 1-2-3 systems with normal conductors" HIGH TC SUPERCONDUCTIVITY: THIN FILMS AND APPLICATIONS, SAN DIEGO, CA, USA, 20-21 MARCH 1990, vol. 1287, 1990, pages 90-103, XP009031827 Proceedings of the SPIE - The International Society for Optical Engineering, 1990, USA ISSN: 0277-786X
- SHARMA R G: "Review on the fabrication techniques of A-15 superconductors" CRYOGENICS, UK, vol. 27, no. 7, July 1987 (1987-07), pages 361-378, XP002283654 ISSN: 0011-2275
- RICHARDSON T J ET AL: "ALUMINUM CLADDING OF HIGH TC SUPERCONDUCTOR BY THERMOCOMPRESSION BONDING" APPLIED PHYSICS LETTERS, AMERICAN INSTITUTE OF PHYSICS. NEW YORK, US, vol. 53, no. 23, 5 December 1988 (1988-12-05), pages 2342-2343, XP000027503 ISSN: 0003-6951

## Description

### FIELD OF THE INVENTION

This invention relates to high temperature ceramic superconductors and, more specifically, to improving the superconducting and mechanical characteristics of these superconducting materials.

### BACKGROUND OF THE INVENTION

The discovery of high critical temperature (T_{c}) ceramic superconductors has inspired an enormous interest in their application. Conventional niobium alloy superconductors such as NbTi must be cooled well below a temperature of 10K to achieve useful superconductivity. High T_{c} superconductors, on the other hand, have T_{c'}s over 100K. Due to the great expense of cryogenic refrigeration, the high T_{c} materials could find much wider application in electronic and laboratory devices. Of particular interest are materials which have T_{c} above 77K, because this is the temperature of liquid nitrogen, a common and relatively inexpensive refrigerant.

Ceramic superconducting materials have not been used in many potential applications because they suffer from a number of shortcomings. The most severe problems with the ceramic superconductors are as follows:
1) They are brittle. They are not flexible and thus cannot be made into wires or other useful shapes. Cracks and boundaries between adjacent crystals severely limit supercurrent flow.
2) They are highly anisotropic. Supercurrents preferentially flow in certain directions with respect to the crystal lattice, reducing maximum supercurrent flow in randomly oriented multicrystalline pieces.
3) They are strong oxidizing agents. Many metals, such as copper, lead, tin, and niobium, are oxidized by contact with the ceramic superconductors, forming an insulating layer which impedes supercurrent flow. Only noble metals such as gold, silver, palladium and their alloys resist being oxidized by the ceramic superconductors.

A less severe undesirable feature of the high temperature ceramic superconductors is that they can lose their superconducting properties. The superconducting structure inside the ceramics has an abundance of oxygen atoms which are necessary for superconductivity. Heating, grinding, etching, or prolonged exposure to ambient atmosphere or vacuum liberates the oxygen and destroys superconductivity. Oxygen content can be restored by annealing the ceramic in an atmosphere with a partial pressure of oxygen.

To overcome the brittleness and anisotropy of the high T_{c} ceramics, the superconducting proximity effect has been exploited in the prior art. For example, U.S. Patent 5,041,416 to Wilson describes a method for making a composite superconducting material. Powders of ceramic superconductor and normal metal are mixed and the mixture is subjected to heat and high pressure. The temperature is controlled during the process such that excessive oxygen is not lost from the ceramic. Silver is preferred as the normal metal. A severe problem with this method is that it attempts to use silver as a proximity superconductor. Silver has poor superconducting properties, and the resultant material therefore has poor superconducting properties. Another problem with this method is that when ceramic and silver powders are mixed, the silver particles tend to clump together, forming a macroscopically inhomogeneous material.

U.S. Patent 5,194,420 to Akihama describes a composite ceramic/metal superconducting material consisting of superconducting ceramic particles dispersed in a metal matrix material. Many different metals are disclosed for use as the normal metal matrix. The noble metals (gold, silver) have poor superconducting properties, and are therefore not capable of carrying much supercurrent. If the non-noble metals are used, they are oxidized by the ceramic, forming an oxide layer which inhibits supercurrent. The oxide layer thus formed also reduces the critical magnetic field of the composite material. A composite material made according to Akihama will have a low supercurrent carrying capability.

U.S. Patent 5,081,072 to Hosokawa et al. describes a method of preparing a superconducting ceramic powder and forming the powder into a superconducting material. Also discussed is the possibility of coating the ceramic particles with silver or gold resulting in a composite material consisting of ceramic particles fused together by the silver or gold. A composite material made only with silver or gold coated ceramic particles has poor superconducting properties, however, and the supercurrent carrying capability of the resultant material will be low. Further, because the silver or gold can only be made to be weakly superconducting, the material will behave poorly in modest magnetic fields.

United States Patent Specification No. US 3,290,186 (being equivalent to German Patent Specification No. DE 1 490 242) (Rosi) discloses a superconducting material that comprises a two-phase mixture of a superconducting metal and a relatively soft, malleable secondary metal. In particular, Rosi teaches a niobium tin (Nb₃Sn) or (V₃Si) superconducting metal combined with a copper (Cu) metal or a lead (Pb) secondary metal. Rosi teaches that such composite materials may be designed with various superconducting transition temperatures by appropriately selecting the proportion between the two components. In particular, transition temperatures of Nb₃Sn-Cu composites in the range 11K-18K may be attained by selecting the proportions from the range from 2 parts Cu and 98 parts Nb₃Sn to 75 parts Cu and 25 parts Nb₃Sn. Significantly, however, Rosi's teaching implies that the proximity effect is irrelevant to his materials. Because Cu and Pb have very different electron-phonon coupling coefficients, they will result in very different proximity effects. Rosi, however, treats Cu and Pb as equally effective secondary materials. Moreover, Rosi does not teach any ceramic supercondustor, does not teach any ceramic/metal superconducting composite, and does not teach any ceramic/metal superconducting composite that employs the proximity effect. There is also no teaching in Rosi that addresses the issues associated with chemical incompatibilities between ceramic superconductors and matrix materials that are useful for enhancing the proximity effect.

United States Patent Specification No. US - 4,050,147 (being equivalent to German Patent Specification No. DE-2 516 747) (Winter) describes superconducting composite materials composed of an A15 metal such as niobium (Nb) or vanadium (V) particles in a ductile metal matrix material such as silver, copper, gold, or aluminum. All of these matrix materials, however, have a very low electron-phonon coupling constants and are not good choices for the fabrication of a high current proximity effect superconducting composite. Although Winter mentions in passing the tunneling of Cooper pairs through the matrix, he does not provide any teaching regarding the proximity effect or how it depends upon the selection of matrix materials. Moreover, Winter does not teach any ceramic superconductor, does not address them chemical incompatibilities between ceramic superconductors and matrix materials, and does not teach any ceramic/metal superconducting composite that employs the proximity effect.

United States Patent Specification No. US-5 098 178 (Ortabasi) describes superconducting material (10) that is a composite of a porous dielectric material (20), ceramic high T_{c} superconducting material particles (22), and a low T_{c} superconducting metal (24) that fills the voids in the porous dielectric (20). The purpose of the dielectric is to hold and bond the ceramic particles in a high density to ensure that the average distance between ceramic particles is comparable to the coherence length of the ceramic material, thereby allowing enhancement through the proximity effect. However, Ortabasi teaches that the metal is in intimate contact with both the ceramic and dielectric, and does not recognize or teach any solution to the problems due to reactivity between the ceramic and the metal. In addition, Ortabasi teaches that, to provide a mechanism for the proximity effect, the metal should have a high thermal and electrical conductivity. Ortabasi also teaches that the metal should have as high a Fermi velocity as possible to increase the current carrying capacity. As examples of such metals, Ortabasi teaches indium, lead, and gallium. These metals, however, are chemically incompatible with ceramic superconductors due to the oxide barrier at the ceramic/metal interface, and result in poor conductive properties of the composite superconductor.

Therefore, there exists a need for a composite superconducting material that has mechanical properties superior to bulk ceramic materials, does not experience problems associated with the chemical reactivity of the ceramic superconductors, has a high critical temperature, and has a high supercurrent carrying capability.

### OBJECTS AND ADVANTAGES OF THE INVENTION

It is an object of the present invention to provide a composite superconducting material that:
1) has a relatively high critical temperature;
2) has improved mechanical properties (such as ductility) compared to ceramic superconductors;
3) chemically insulates the ceramic superconducting material from the proximity superconducting material;
4) has increased isotropy compared to bulk ceramic superconductors;
5) has increased critical current density compared to the prior art composite superconducting materials; and
6) has increased ability to remain superconducting in applied magnetic fields compared to the prior art superconducting materials.

Further objects and advantages will be apparent upon reading the following description with reference to the drawings.

### SUMMARY OF THE INVENTION

These objects and advantages are attained by a composite superconducting material comprising a plurality of ceramic superconductor particles. Each of the ceramic particles is coated with a thin layer of noble material which is chemically nonreactive with the ceramic particles. The coated ceramic particles are disposed in a metal matrix material which fills the regions between the particles. The metal matrix material is an intrinsic superconductor having a critical temperature lower than the critical temperature of the ceramic particles. In addition, the matrix material has an electron-phonon coupling coefficient greater than 0.5. The matrix material is thus susceptible to a superconducting proximity effect induced by the ceramic particles, and the ceramic particles are electrically coupled due to the proximity effect.

A method for producing the composite superconducting material includes the step of forming a plurality of particles of a ceramic superconductor material. Each of the ceramic particles is coated with a thin layer of the noble material. The method also includes the step of providing a plurality of particles of the metal matrix material. The coated ceramic particles and the matrix material particles are then thoroughly mixed. The mixture is then fused to form a solid material.

An alternative method for producing the composite superconductor material includes the step of providing a plurality of particles of the ceramic superconductor material. Each of the ceramic particles is coated with a thin layer of the noble material. A coating of the metal matrix material is then applied to each ceramic particle on top of the noble material coating. The coated ceramic particles are then fused to form a solid material.

Possible metal matrix materials include niobium, indium, NbTi alloy, tin, lead, lead/bismuth alloys, and alloys thereof. In the preferred embodiment, the metal matrix material is NbTi alloy. The noble material is preferably silver, but other noble materials which are not reactive with the ceramic superconductor particles may also be used. For example, other noble materials which may be coated on the ceramic particles include gold, palladium, and alloys of gold, palladium or silver.

The layer of noble material which is coated on each ceramic particle is preferably thinner than the decay length of the noble material. Also, the noble material should be sufficiently thick to chemically insulate the ceramic particles. Preferably, the thickness of the noble material layer is in the range of 5 to 3000 nanometers. If silver is used as the noble material, the thickness of the silver layer is preferably 5 nanometers. It is also preferred that the noble material be permeable to oxygen at least one temperature.

The ceramic particles are preferably comprised of a cuprate superconductor ceramic material. The ceramic particles are also preferably larger than the superconducting coherence length of the ceramic material of which they are made. Preferably, the particles have physical dimensions in the range of 1.5 nanometers to 10 micrometers.

### BRIEF DESCRIPTION OF THE FIGURES

- Fig.: **1A** is a graph of the superconducting gap magnitude in a relatively high λ proximity superconductor.
- Fig.: **1B** is a graph of the superconducting gap magnitude in a relatively low λ proximity superconductor.
- Fig.: **2** is a cross sectional view of an intrinsic superconductor inside a proximity superconductor.
- Fig.: **3** is a cross sectional view of a high T_{c} cuprate ceramic embodiment of the composite superconducting material of the present invention.
- **Fig.**: **4A** is a graph of the conventional, incorrect understanding of the superconducting gap in a three layer junction with a low-λ metal in the middle.
- **Fig.**: **4B** is a graph of a new understanding of the superconducting gap in a three layer junction with a low-λ metal in the middle.
- Fig.: **5** is a cross sectional view of a row of intrinsic superconducting particles in a metal matrix illustrating how a supercurrent can travel through the proximity superconducting regions.

### DETAILED DESCRIPTION

The present invention exploits the superconducting proximity effect to provide a composite superconducting material. The superconducting proximity effect occurs at the boundary between a normal conductor (a metal) and an intrinsic superconductor. The intrinsic superconductor induces the normal conductor to become superconducting near the boundary. The proximity superconductor has all the properties of a true superconductor. It expels magnetic fields, has a critical current density, and a superconducting gap. Also, the proximity superconductors isotropic, and thus, is able to conduct supercurrent in any direction.

The superconducting gap is an absence of electron energy states near the Fermi energy in a superconductor. It arises from the pairing of the electrons in the material which occurs at the superconducting critical temperature. The magnitude of the critical current density in any superconducting material is proportional to the superconducting gap. Thus, the larger the superconducting gap, the larger will be the critical current density of the material.

Since the proximity effect has an exponential decay characteristic as a function of the distance from the intrinsic/proximity superconductor boundary, it is possible to specify a decay length. The decay length is the length over which the superconducting gap (and therefore the critical current density) of the proximity superconductor decreases by a factor of 1/e. The decay length is determined by the proximity superconductor and the temperature, to which it is inversely proportional. Silver, for example, has decay lengths of 22 nm and 44 nm at temperatures of 77K and 38.5K, respectively. **Table 1** shows the decay lengths for a number of different metals.

**TABLE 1**

| Metal | Decay Length at 77K |
|---|---|
| Lead | 29 nanometers |
| Tin | 30 nanometers |
| Indium | 30 nanometers |
| NbTi | 22 nanometers |
| Niobium (Nb) | 22 nanometers |
| Mercury | 25 nanometers |
| Silver | 22 nanometers |
| Gold | 22 nanometers |
| Copper | 25 nanometers |

A property of a proximity superconductor that is essential for understanding the proximity effect is the electron-phonon coupling coefficient, λ. While the decay length affects how rapidly (with distance) the superconducting gap decreases, λ affects the magnitude of the superconducting gap of the proximity superconductor. A high electron-phonon coupling coefficient results in a high superconducting gap and a high critical current density. The λ values for a number of different metals are given in **Table 2.**

**TABLE 2**

| Metal | Electron-Phonon Coupling, λ |
|---|---|
| Lead | 1.55 |
| Tin | 0.72 |
| Indium | 0.82 |
| NbTi | 0.92 |
| Niobium (Nb) | 1.22 |
| Mercury | 1.00 |
| Silver | 0.14 |
| Gold | 0.14 |
| Copper | 0.08 |
| Lead/Bismuth Alloys | 2-3 |

The value of λ is a fundamental property of the electronic structure of a metal. Due to the nature of electron-phonon coupling, metals with a high value of λ (i.e., λ = 1 to 2, such as lead, lead/bismuth alloys, tin, and NbTi alloys) generally have high resistivities and higher superconducting critical temperatures. Metals with low values for λ (i.e., λ = 0.1 to 0.2, such as silver and gold) generally have low resistivities and lower or no critical temperatures. Empirically, it is observed that high λ metals are more easily oxidized than low λ metals.

All other factors being equal, high-λ proximity superconductors always have a larger superconducting gap, and therefore a larger critical current density, than low-λ proximity superconductors. It is noted that λ=0 for insulators.

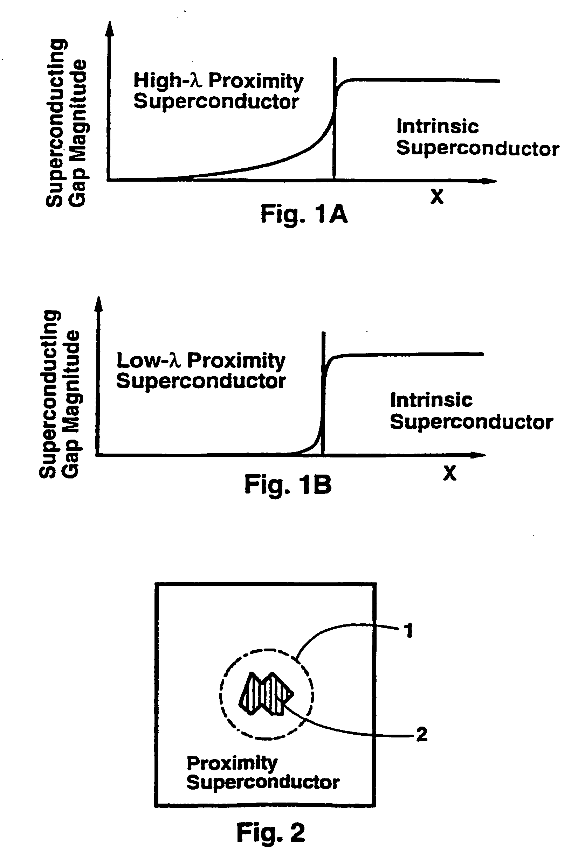

**Figs. 1A** and **1B** show the magnitudes of the superconducting gap for a high-λ proximity superconductor and a low-λ proximity superconductor, respectively. The high-λ proximity superconductor has a larger superconducting gap. Both curves are proportional to e^{-kx}, where k is the decay length and x is the perpendicular distance from the boundary. Large supercurrents can be carried in proximity superconductors with long decay lengths and large λ values. Since the decay length is inversely proportional to temperature, low temperatures enhance the proximity effect.

It is noted that the critical current density is an important characteristic of superconducting materials because it is the maximum current density the material can carry. Many applications such as magnets demand high supercurrent density. It is desirable for superconducting materials to have as high a critical current density as possible.

**Fig. 2** shows a piece of an intrinsic superconductor **2** disposed inside a block of a proximity superconductor. The intrinsic superconductor **2** causes the proximity superconductor to become superconducting near the boundary of the two materials. The range of the proximity effect is represented by the circle **1.** The range of the proximity effect is much larger for proximity superconductors having a long decay length and a high electron-phonon coupling coefficient.

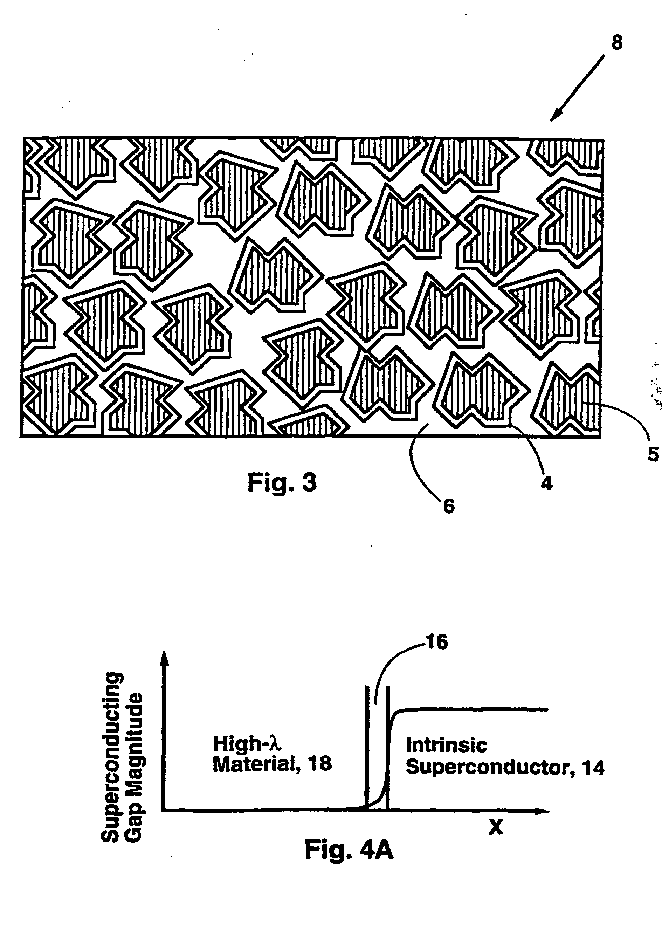

**Fig. 3** shows a magnified cross sectional view of a ceramic composite superconducting material **8** according to a preferred embodiment of the present invention. The composite material **8** comprises superconducting high T_{c} cuprate ceramic particles **5** each having a coating of a thin layer of noble material **4.** The coated ceramic particles **5** are surrounded by a metal matrix material **6.** The metal matrix material preferably completely fills the regions between the coated ceramic particles. Although the ceramic particles **5** are hard and brittle, the composite material **8** is relatively ductile because the metal matrix material **6** is ductile. The composite material **8** may be placed in a silver or copper tube and drawn to form a relatively flexible wire.

The ceramic particles **5** have physical dimensions larger than the superconducting coherence length of the ceramic. Typically, the coherence length of high T_{c} cuprate ceramics is about 1.5 nanometers. Preferably, the ceramic particles **5** are uniform in size and have physical dimensions in the range of 0.5 to 1.0 micrometers. More generally, the ceramic particles can have physical dimensions in the range of 1.5 nanometers to about 10 micrometers. The ceramic particles **5** may be single crystals or multicrystalline.

The noble material **4** is selected to be chemically nonreactive with the superconducting ceramic particles **5.** The cuprate ceramics are strong oxidizing agents and will oxidize all but the most noble metals such as silver, gold, palladium and their alloys. If a non-noble, oxidizable metal is contacted to the ceramic particles **5,** an insulating metal oxide layer will form which blocks the superconducting proximity effect. For this and other reasons such as cost, silver is the preferred noble material.

The layer of noble material **4** coated on each ceramic particle should be thinner than the proximity effect decay length of the noble material. For silver, a coating thickness of 5 nm is acceptable as the proximity effect decay length in silver is 22 nm (at 77K). The maximum useful thickness of the noble material layer is about 3000 nanometers. Also, the layer of noble material **4** coated on each ceramic particle should be thick enough to chemically insulate the particle from the matrix material **6.**

Both the noble material/ceramic and noble material/metal matrix material interfaces should be clean and free of insulating contaminants to facilitate electrical contact across the interfaces. This is because insulating contaminants will block the superconducting proximity effect.

The metal matrix material **6** is selected to have a large electron-phonon coupling coefficient λ, and preferably a long superconducting decay length. A large value of λ means that it is highly susceptible to the superconducting proximity effect. The combination of a long decay length and large electron-phonon coupling coefficient results in a large proximity effect extending deep into the metal matrix material **6.** This is preferable as it increases the critical current density and improves the mechanical properties of the composite material **8** by allowing for greater distances between adjacent ceramic particles **5.** The metal matrix material should have an electron-phonon coupling coefficient greater than about 0.5. The metal matrix material **6** should also be ductile to impart ductility to the composite material **8.** Possible metal matrix materials include niobium, indium, NbTi alloy, tin, lead, lead/bismuth alloys, and alloys thereof. Preferably, the metal matrix material is NbTi alloy.

The noble material **4** is selected to be chemically nonreactive with the ceramic particles **5.** It has been empirically observed that materials having a high electron-phonon coupling coefficient are generally more reactive than materials having a low electron-phonon coupling coefficient. Therefore, a noble material which is sufficiently inert to remain unoxidized while in contact with a cuprate ceramic will likely have a low electron-phonon coupling coefficient. Silver, for example, has an electron-phonon coupling coefficient of 0.14.

The composite material **8** as a whole is superconducting because the ceramic particles **5** cause the surrounding metal matrix material **6** to become superconducting via the proximity effect. The proximity effect extends from the ceramic particles **5** and through the layer of noble material **4** because the layer is substantially thinner than the decay length of the noble material. This is significant because, prior to the development of the present invention, conventional superconductor theory held that the superconducting proximity effect could not extend through even a thin layer of a low-λ metal such as the noble metals (silver, gold, palladium).

The conventional understanding of the proximity effect in a three layer junction is illustrated in the cross sectional view of **Fig. 4A.** The junction comprises an intrinsic superconductor **14,** a thin layer of low-λ material **16,** and a high-λ material **18.** The superconducting gap clearly drops to nearly zero in the low-λ material **16** and stays at nearly zero in the high-λ material **18.** Thus, the high-λ material **18** is not superconducting according to the incorrect conventional understanding.

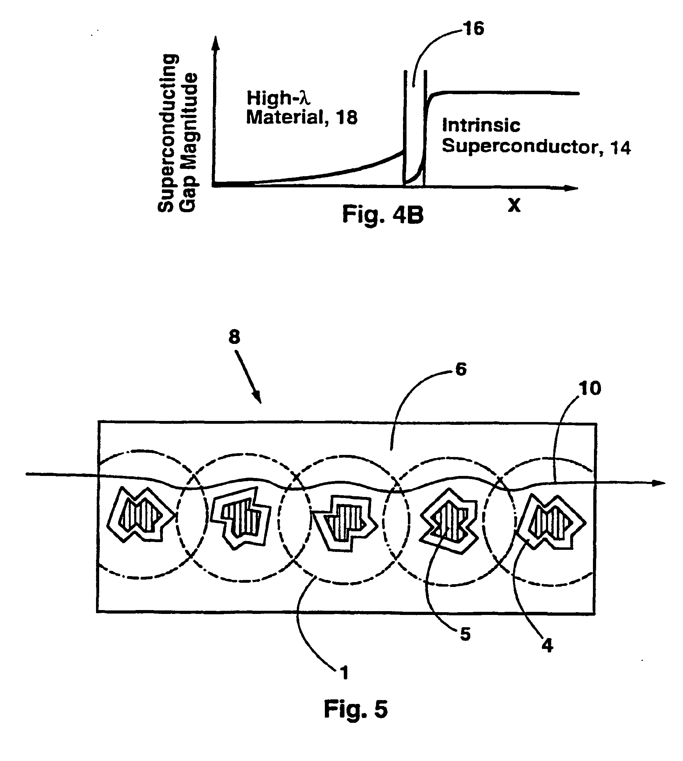

What actually happens in the three layer junction is shown in **Fig. 4B.** The superconducting gap rebounds in the high-λ material **18,** provided that the low-λ layer **16** is thin compared to the decay length of the low-λ material. Thus, making a superconducting composite material **8** is possible even if the intrinsic superconductor is surrounded by a layer of low-λ material **16.** The fact that the superconducting proximity effect can extend through a layer of a low-λ material was discovered by the present inventor.

Returning to **Fig. 3,** it is noted that each layer of noble material **4** is somewhat detrimental to the superconducting properties of the composite material **8** because it likely has a low electron-phonon coupling coefficient. Therefore, it is best to make each layer of noble material as thin as possible, while still providing chemical insulation for the ceramic particles **5.**

The superconductivity of the surrounding metal matrix material **6** is enhanced via the proximity effect when the T_{c} of the ceramic particles **5** is higher than the T_{c} of the metal matrix material **6.** This is the case for most combinations of cuprate ceramics and metal matrix materials (such as NbTi).

The composite material **8** should be designed such that adjacent ceramic particles **5** are electrically coupled due to the proximity effect. In other words, the nonzero superconducting gap functions induced in the metal matrix material **6** by adjacent ceramic particles **5** must overlap. If the ceramic particles **5** are too far apart, the critical current density of the composite material **8** will be reduced because the superconducting gap function will be smaller in the regions of the metal matrix **6** which are far from the ceramic particles **5.** It is noted that if the ceramic particles are separated by a relatively large distance, then the T_{c} of the composite material may be lower than the T_{c} of the ceramic.

**Fig. 5** illustrates how a supercurrent **10** can travel through the composite material **8** by staying within the regions induced to be superconducting through the proximity effect. The circles **1** illustrate the approximate range of the proximity effect. The circles **1** should overlap in order to provide a continuous path for the supercurrent **10.** The range of the proximity effect induced by the ceramic particles **5** will depend upon the temperature of the composite material **8,** the properties of the matrix material **6** and of the noble material **4,** and the thickness of the layer of noble material **4.**

A method for making the composite superconducting material **8** begins with selecting a suitable ceramic superconductor. Several possible ceramic superconductors are shown in **Table 3.** YBa₂Cu₃O₇ is preferred for many applications because of its high flux pinning strength and high T_{c}. A high flux pinning strength allows the material to conduct supercurrent in high magnetic fields without energy loss.

**TABLE 3**

| Ceramic Superconductor | Critical Temperature. T_{c} |
|---|---|
| YBa₂Cu₃O₇ | 95K |
| Bi₂Sr₂Ca₂Cu₃O₁₀ | 105K |
| Bi₂Sr₂Ca₁Cu₂O₈ | 85K |
| (BiPb)₂Sr₂Ca₂Cu₃O₁₀ | 110K |
| Tl₂Ba₂Ca₂Cu₃O₁₀ | 125K |
| Tl₂Ba₂Ca₁Cu₂O₈ | 105K |

The superconducting ceramic is first formed into a powder which can be accomplished by many techniques known in the art, such as grinding. Preferably, the ceramic particles of the powder are in the size range of 0.5 to 1.0 micrometers. The best size range will depend upon the temperature at which the material is used, and the λ and decay length of the metal matrix material. The ceramic particles of the powder are then cleaned by plasma etching. Cleaning prepares the surface of the ceramic particles to bond to the coating of noble material. Plasma etching techniques for the high T_{c} cuprate ceramics are well known in the art.

Each ceramic particle is then coated with a uniform layer of the noble material. The layer of noble material completely surrounds the ceramic particle. Preferably, silver is the noble material. Silver is preferred because it is easily applied as a coating, is permeable to oxygen, and is the least expensive of the metals that are not oxidized by the high T_{c} cuprate ceramics. Silver can be deposited using a number of techniques well known in the art, such as chemical deposition and vapor deposition.

A chemically deposited silver coating is formed by stirring the ceramic particles in a nonaqueous solution of a silver salt and adding a reducing agent. The silver is reduced and it precipitates on the surfaces of the ceramic particles. The silver solution should be nonaqueous because water adversely affects the ceramic particles. Alternatively, a vapor deposited coating may be formed by sifting the ceramic particles in a vacuum chamber containing a partial pressure of silver vapor. Both methods form clean silver coatings of accurate thickness. The silver coating is preferably 5 nm in thickness and completely surrounds the ceramic particle. The silver coating is thick enough to chemically insulate the ceramic particle.

After the ceramic particles are coated with the noble material, the ceramic particles are replenished with oxygen. Replenishment is performed by heating the coated ceramic particles in an atmosphere with a partial pressure of oxygen. Since silver is permeable to oxygen at elevated temperatures (300°C and up) , oxygen reaches the ceramic. The best temperature, oxygen pressure, and annealing time is specific to each high T_{c} ceramic and is selected to optimize the superconducting properties of each ceramic. Such annealing techniques for silver coated cuprate ceramics are well known in the art.

The coated ceramic particles are then intimately mixed with particles of the metal matrix material. Preferably, mixing is performed at room temperature to avoid the formation of clumps. Preferably, the metal matrix material particles have physical dimensions in the range of 0.5 to 1.0 micrometers. Also preferably, the metal matrix material is a NbTi alloy. The volume ratio of ceramic particles to metal matrix material may be adjusted to optimize the superconducting properties of the composite material. Preferably, the composite material contains less than 50% by volume of the metal matrix material. **Table 4** shows the decay lengths and electron-phonon couplings for several possible matrix material candidates.

**TABLE 4**

| Metal | e-Phonon Coupling, λ | Decay Length at 77K |
|---|---|---|
| NbTi | 0.92 | 22 nanometers |
| Indium | 0.82 | 30 nanometers |
| Niobium | 1.22 | 22 nanometers |
| Lead | 1.55 | 29 nanometers |
| Tin | 0.72 | 30 nanometers |
| Lead/Bismuth Alloys | 2-3 | 25-28 nanometers |

The mixture is then compressed to fuse the particle mixture into a solid material. Applicable powder-fusing metallurgical techniques are well known in the art. Since the metal matrix material is ductile, it will flow under pressure to fill the regions between the coated ceramic particles. Preferably, no voids remain after the particle mixture is fused. Voids can be reduced by exposing the particle mixture to vacuum before fusing. Many different useful shapes can be created by disposing the particle mixture into a mold and compressing the mold. The particle mixture can be formed into a wire by placing it into a copper or silver tube and repeatedly drawing the tube to ever smaller diameters.

According to an alternative method for making the composite superconducting material **8**, the coated ceramic particles are covered with a layer of the metal matrix material instead of being mixed with particles of the metal matrix material. The thickness of the metal matrix material coating then determines the distance between adjacent ceramic particles. The matrix material coating can be formed with chemical or physical coating techniques similar to the techniques used to apply the coating of noble material. Such techniques are well known in the art. Ceramic particles having a two layer noble material and metal matrix material coating are then fused using the same powder metallurgical techniques described above.

## Claims

1. A composite superconducting material comprising:
a) a plurality of particles composed of a ceramic superconductor material, wherein each of the particles has physical dimensions larger than a superconducting coherence length of the ceramic superconductor material; and
b) a matrix material surrounding the particles; wherein the matrix material is a superconductor having an electron-phonon coupling coefficient greater than 0.5 and a superconducting critical temperature less than a superconducting critical temperature of the ceramic superconductor material; and
c) a coating material covering each of the particles, wherein the coating material is chemically nonreactive with the ceramic superconductor material;
wherein, at a temperature greater than the superconducting critical temperature of the matrix material and less than the superconducting critical temperature of the ceramic superconductor material, the particles induce regions of the matrix material around the particles to be superconducting within a range of the superconducting proximity effect of the matrix material, wherein the regions around adjacent particles overlap.

2. A material as claimed in claim 1 wherein the ceramic superconductor material is a high-Tc oxide.

3. A material as claimed in claim 1 or claim 2 wherein the coating material:
(a) has a thickness less than a superconducting proximity effect decay length of the coating material at 77 K; or
(b) is a metal having an electron-phonon coupling coefficient between 0.1 and 0.2; or
(c) comprises silver.

4. A material as claimed in any of claims 1-3 in the form of a wire.

5. A method for producing a composite superconducting material, the method comprising:
a) coating a plurality of particles composed of ceramic superconductor material with a coating material chemically nonreactive with the ceramic superconductor material; wherein the particles have physical dimensions larger than a superconducting coherence length of the ceramic superconductor material;and
b) mixing and fusing the coated particles with a matrix material, not necessarily distinct from the coating material; wherein the matrix material is a superconductor having an electron-phonon coupling coefficient greater than 0.5 and a superconducting critical temperature less than a superconducting critical temperature of the ceramic superconductor material.

6. A method as claimed in claim 5 wherein the ceramic superconductor material is a high-Tc oxide.

7. A method as claimed in claim 5 or claim 6 wherein each of the coated particles has a layer of coating material having a thickness less than a superconducting proximity effect decay length of the coating material at 77 K.

8. A method as claimed in any of claims 5-7 wherein the coating material
a) is a metal having an electron-phonon coupling coefficient between 0.1 and 0.2; or
b) comprises silver.

## Patentansprüche

1. Supraleitendes Verbundmaterial, das Folgendes umfasst:
a)
a) eine Mehrzahl von Partikeln, die aus einem supraleitenden Keramikmaterial bestehen, wobei jeder der Partikel physische Abmessungen hat, die größer sind als eine supraleitende Kohärenzlänge des supraleitenden Keramikmaterials; und
b)
b) ein die Partikel umgebendes Matrixmaterial, wobei das Matrixmaterial ein Supraleiter mit einem Elektron-Phonon-Kopplungskoeffizient über 0,5 und einer kritischen Supraleitungstemperatur ist, die niedriger ist als eine kritische Supraleitungstemperatur des supraleitenden Keramikmaterials; und
c)
c) ein Beschichtungsmaterial, das jeden der Partikel bedeckt, wobei das Beschichtungsmaterial mit dem supraleitenden Keramikmaterial chemisch nicht reaktionsfähig ist;
wobei die Partikel bei einer Temperatur, die über der kritischen
Supraleitungstemperatur des Matrixmaterials und unter der kritischen Supraleitungstemperatur des supraleitenden Keramikmaterials liegt, Regionen des Matrixmaterials um die Partikel innerhalb eines Bereiches des supraleitenden Naheffekts des Matrixmaterials supraleitend machen, wobei die Regionen um benachbarte Partikel überlappen.

2. Material nach Anspruch 1, bei dem das supraleitende Keramikmaterial ein Oxid mit hohem Tc-Wert ist.

3. Material nach Anspruch 1 oder Anspruch 2, bei dem das Beschichtungsmaterial:
a)
a) eine Dicke aufweist, die geringer ist als die Abklinglänge des supraleitenden Naheffekts des Beschichtungsmaterials bei 77 K; oder
b)
b) ein Metall mit einem Elektron-Phonon-Kopplungskoeffizient zwischen 0,1 und 0,2 ist; oder
c)
c) Silber umfasst.

4. Material nach einem der Ansprüche 1-3 in der Form eines Drahtes.

5. Verfahren zum Erzeugen eines supraleitenden Verbundmaterials, wobei das Verfahren die folgenden Schritte umfasst:
a)
a) Beschichten einer Mehrzahl von Partikeln, die aus einem supraleitenden Keramikmaterial mit einem Beschichtungsmaterial bestehen, das mit dem supraleitenden Keramikmaterial chemisch nicht reaktionsfähig ist; wobei die Partikel physische Abmessungen haben, die größer sind als eine supraleitende Kohärenzlänge des supraleitenden Keramikmaterials; und
b)
b) Mischen und Fusionieren der beschichteten Partikel mit einem Matrixmaterial, das sich nicht unbedingt von dem Beschichtungsmaterial unterscheidet; wobei das Matrixmaterial ein Supraleiter mit einem Elektron-Phonen-Kopplungskoeffizient von mehr als 0,5 ist und einer kritischen Supraleitungstemperatur ist, die niedrger ist als eine kritische Supraleitungstemperatur des supraleitenden Keramikmaterials.

6. Verfahren nach Anspruch 5, bei dem das supraleitende Keramikmaterial ein Oxid mit hohem Tc-Wert ist.

7. Verfahren nach Anspruch 5 oder Anspruch 6, bei dem jeder der beschichteten Partikel eine Schicht aus Beschichtungsmaterial mit einer Dicke hat, die geringer ist als eine Abklinglänge des supraleitenden Naheffekts des Beschichtungsmaterials bei 77 K.

8. Verfahren nach einem der Ansprüche 5-7, wobei das Beschichtungsmaterial:
a)
a) ein Metall mit einem Elektron-Phonon-Kopplungskoeffizient zwischen 0,1 und 0,2 ist; oder
b)
b) Silber umfasst.

## Revendications

1. Un matériau composite supraconducteur comprenant :
a) une pluralité de particules composées d'un matériau supraconducteur céramique, où chacune de ces particules possède des dimensions physiques supérieures à une longueur de cohérence supraconductrice du matériau supraconducteur céramique ; et
b) un matériau à matrice entourant les particules ; où le matériau à matrice est un supraconducteur possédant un coefficient de couplage électron-phonon supérieur à 0,5 et une température critique supraconductrice inférieure à une température critique supraconductrice du matériau supraconducteur céramique ; et
c) un matériau d'enrobage couvrant chacune des particules, où le matériau d'enrobage est chimiquement inerte au matériau supraconducteur céramique ; où, à une température supérieure à la température critique supraconductrice du matériau à matrice et inférieure à la température critique supraconductrice du matériau supraconducteur céramique, les particules amènent des zones du matériau à matrice autour des particules à devenir supraconductrices à l'intérieur d'une plage de l'effet de proximité supraconducteur du matériau à matrice, où les zones autour des particules adjacentes se chevauchent.

2. Un matériau selon la Revendication 1 où le matériau supraconducteur céramique est un oxyde à Tc élevée.

3. Un matériau selon la Revendication 1 ou 2 où le matériau d'enrobage :
(a) possède une épaisseur inférieure à une longueur de déclin de l'effet de proximité supraconducteur du matériau d'enrobage à 77 K ; ou
(b) est un métal possédant un coefficient de couplage électron-phonon situé entre 0,1 et 0,2 ; ou
(c) contient de l'argent.

4. Un matériau selon l'une quelconque des Revendications 1 à 3 de la forme d'un fil.

5. Un procédé pour produire un matériau composite supraconducteur, le procédé comprenant :
a) l'enrobage d'une pluralité de particules composées d'un matériau supraconducteur céramique avec un matériau d'enrobage chimiquement inerte au matériau supraconducteur céramique ; où les particules possèdent des dimensions physiques supérieures à la longueur de cohérence supraconductrice du matériau supraconducteur céramique ; et
b) le mélange et la fusion des particules enrobées avec un matériau à matrice, non nécessairement distinct du matériau d'enrobage ; où le matériau à matrice est un supraconducteur possédant un coefficient de couplage électron-phonon supérieur à 0,5 et une température critique supraconductrice inférieure à la température critique supraconductrice du matériau supraconducteur céramique.

6. Un procédé selon la Revendication 5 où le matériau supraconducteur céramique est un oxyde à Tc élevée.

7. Un procédé selon la Revendication 5 ou 6 où chacune des particules enrobées possède une couche de matériau d'enrobage ayant une épaisseur inférieure à une longueur de déclin de l'effet de proximité supraconducteur du matériau d'enrobage à 77 K.

8. Un procédé selon l'une quelconque des Revendications 5 à 7 où le matériau d'enrobage
a) est un métal possédant un coefficient de couplage électron-phonon situé entre 0,1 et 0,2 ; ou
b) contient de l'argent.
